**Europäisches Patentamt**

**European Patent Office**

**Office européen des brevets**

(19)

(11) Veröffentlichungsnummer: **0 032 727**
**B1**

# EUROPÄISCHE PATENTSCHRIFT

(12)

(45) Veröffentlichungstag der Patentschrift:
**11.07.84**

(51) Int. Cl.³: **H 03 K 17/97, G 01 V 3/08**

(21) Anmeldenummer: **81100274.0**

(22) Anmeldetag: **15.01.81**

(54) **Verfahren zum Herstellen einer Magnetschranke.**

(30) Priorität: **18.01.80 DE 3001771**

(43) Veröffentlichungstag der Anmeldung:
**29.07.81 Patentblatt 81/30**

(45) Bekanntmachung des Hinweises auf die Patenterteilung:
**11.07.84 Patentblatt 84/28**

(84) Benannte Vertragsstaaten:
**FR GB IT**

(56) Entgegenhaltungen:
**FR - A - 2 438 345**
**US - A - 4 156 820**

**IEEE VEHICULAR TECHNOLOGY CONFERENCE,
Arlington Heights, Ill. 27-30. März 1979 NEW YORK (US)
M.J. THORN: "A Monolitic Linear Hall Effect Integrated
Circuit" Seiten 226-229**

(73) Patentinhaber: **SIEMENS AKTIENGESELLSCHAFT,
Berlin und München Witteisbacherplatz 2,
D-8000 München 2 (DE)**

(72) Erfinder: **Ertl, Wilhelm, Sudetenstrasse 25,
D-8012 Ottobrunn (DE)**
Erfinder: **Lachmann, Ulrich, Ing.grad., Isartalstrasse 81,
D-8000 München 70 (DE)**
Erfinder: **Pertsch, Heinrich, Franziskanerstrasse 16,
D-8000 München 80 (DE)**

ACTORUM AG

**Beschreibung**

Die Erfindung betrifft ein Verfahren zum Herstellen einer Magnetschranke, bei dem die zu erzeugende Magnetschranke aus einem Magneten mit einem einen ebenen Oberflächenteil aufweisenden Pol sowie aus einem mit einer integrierten Schaltung versehenen Halbleiterchip besteht.

Es wurde bereits versucht, Magnetschranken der soeben angegebenen Art so herzustellen, dass ein mit einer integrierten Schaltung versehenes Siliciumchip mit Hilfe der sogenannten Flip-Chip-Technologie, und zwar mittels weicher Bumps auf einer Keramiksubstratplatte aufgebracht und mit einem Deckel abgedeckt wird. Auf der Keramiksubstratplatte werden Leitbahnen angebracht, die einerseits zu den Bumps des Siliciumchips führen und die an den Rändern des Keramiksubstrats mit angelöteten Anschlussdrähten versehen sind. Ein Magnet und das Siliciumchip werden in ein vorgefertigtes Gehäuse so eingebracht, dass ein ebener Flächenanteil eines Magnetpols parallel zu den beiden grössten Oberflächenteilen des Siliciumchips verläuft und dass das Siliciumchip sich auf gleicher Höhe mit dem parallel verlaufenden Magnetpolflächenteil befindet. Ausserdem wird in das vorgefertigte Gehäuse ein Magnetflussblech eingeführt, das dem Deckel des Siliciumchips gegenüberliegt und an dieser Stelle mit einer Erhöhung versehen ist. Der verwendete Magnet besteht aus Alnico.

Das verwendete Gehäuse weist seitliche Schlitze parallel zur Keramiksubstratplatte auf. Diese Schlitze müssen bei einem anschliessenden Plastikverguss zuvor abgedeckt werden, was technische Schwierigkeiten bereitet und einen zusätzlichen Arbeitsaufwand erfordert.

Weiterhin bedingt die Verwendung eines Keramiksubstrats, abgesehen von einer niedrigen Stoss- und Bruchsicherheit, Nachteile bezüglich des Herstellungsverfahrens, insbesondere auch einen erheblichen Arbeitsaufwand, zumal auch dann die Automatisierung des Herstellungsverfahrens in Frage gestellt ist.

Aufgabe der Erfindung ist es, ein Verfahren zur Herstellung einer Magnetschranke entsprechend der eingangs gegebenen Definition anzugeben, welches zu Magnetschranken führt, bei denen die sonst auf das Halbleiterchip einwirkenden und aufgrund des Herstellungsverfahrens bedingten mechanischen Spannungen und damit die durch diese Spannungen bedingten Piezoeffekte beseitigt sind.

Hierzu wird gemäss der Erfindung vorgesehen, dass das in Mikropack-Bauform vorliegende Halbleiterchip auf einen dünnen, mit fingerartigen Kontaktstrukturen versehenen und z.B. aus einem Kunststoffband bestehenden Zwischenträger aufgelötet und der Zwischenträger mit einem für die Aufnahme der Oberseite des Halbleiterchips mit einer Aussparung versehenen sowie einen ersten Teil eines Magnetleitblechs bildenden Polschuh fest verbunden wird, dass ausserdem auf den Zwischenträger eine mit Kontaktstrukturen versehene Kunststoffplatine an zugehörigen Kontaktstellen des Zwischenträgers aufgelötet und die Kunststoffplatine an den äusseren Enden der Kontaktstrukturen mit äusseren Anschlussdrähten versehen wird, dass ferner der Magnet an einem weiteren Teil des Magnetleitblechs befestigt wird und dass schliesslich die beiden zunächst noch voneinander getrennten Teile des Magnetleitblechs derart zueinander in Position gebracht werden, dass der Polschuh mit dem Halbleiterchip einerseits und ein ebener Oberflächenteil des Magneten andererseits mit Abstand einander gegenüber angeordnet sind und in dieser Position die beiden Teile des Magnetleitblechs abseits vom Halbleiterchip mit dem Magneten und Polschuh in unmittelbarer magnetischer Verbindung miteinander stehen und dass dann diese Position unter Anwendung einer Einbettung aus isolierendem Kunststoff fixiert wird.

Neben der Lösung der genannten Aufgabe bringt das erfindungsgemässe Verfahren den Vorteil, dass das Bauelement bereits vor dem Vergiessen mit einer Vergussmasse funktionstüchtig ist, so dass in diesem Zustand bereits verschiedene Kontrollmessungen durchgeführt werden können und fehlerhafte oder fehlerhaft montierte Bauteile bereits zu diesem Zeitpunkt erkannt und ausgewechselt werden können, so dass der durch Ausschuss-Bauelemente bedingte Verlust gering gehalten wird. Dies ist insbesondere im Hinblick auf die Verwendung von teuren Samarium-Kobalt-Magneten von Bedeutung. Ausserdem lässt sich, wie bereits erwähnt, das Verfahren ohne weiteres automatisieren.

Bei der Verwendung von Halbleiterchips, bei denen keine Massnahmen zur Kompensation von Piezoeffekten getroffen sind, ist es wichtig, das Halbleiterchip innerhalb der zu erzeugenden Magnetschranke so zu montieren, dass es vor mechanischen Belastungen geschützt ist. Deshalb wird bei dem erfindungsgemässen Verfahren das Halbleiterchip nicht direkt auf einem Träger oder Magnetleitblech befestigt. Vielmehr wird lediglich eine Kunststoffolie, z.B. eine Kaptonfolie, am Magnetleitblech befestigt sowie das Halbleiterchip nur mittels feiner Kontaktfinger mit der Kunststoffolie verbunden, während letzteres ansonsten freischwebend in einem speziell geformten Polschuh des Magnetleitblechs in einer Vertiefung desselben angebracht wird. Vorteilhaft ist dabei, dass der Spalt zwischen dem Magnetpol und dem Halbleiterchip möglichst klein eingestellt wird.

Durch die speziell gewählte Polschuhform und das Ersetzen der bisher üblichen Keramikplatte durch eine Epoxidplatte ist es möglich, einerseits den Spalt zwischen Magnet und Halbleiterchip zu verringern, da die Epoxidplatte eine geringere Schichtdicke aufweist, und andererseits ist es auch möglich, den Spalt zwischen Halbleiterchip und Polschuh am Magnetleitblech durch eine geeignete Formgebung des Polschuhs zu verringern, weil gleichzeitig eine Abschlusskappe für das Halbleiterchip eingespart wird.

Der zu verwendende Magnet besteht vorteilhafterweise aus einer Samarium-Kobalt-Legierung. Solche Magneten weisen bei gleichen Abmessungen eine grössere Magnetfeldstärke als die üblicherweise verwendeten Magneten aus anderen ferromagnetischen Stoffen, z.B. aus Alnico, auf. Ausserdem ist das Magnetfeld solcher Samarium-Kobalt-Magnete zeitlich stabiler als z.B. das der Alnico-Magnete, so dass die Einsatzfähigkeit einer Magnetschranke mit einem Samarium-Kobalt-Magneten für eine längere Zeit als die bei Verwendung anderer Ferromagnetica gewährleistet ist.

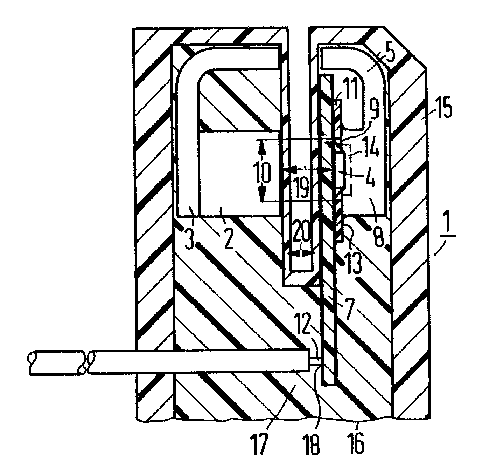

Bei der ersten und anhand der Figur ersichtlichen Variation einer erfindungsgemäss hergestellten Magnetschranke werden die beiden Teile des Magnetleitblechs in ein vorgefertigtes und z.B. aus Kunststoff bestehendes Gehäuse derart eingeschoben, dass die aktiven Teile der Magnetschranke in die für das Funktionieren erforderliche und bereits definierte Position zueinandergelangen. Dabei ist auf eine spaltartige Einbuchtung des Gehäuses hinzuweisen, die derart in bezug auf den Magneten, den Polschuh und den Halbleiterchip anzuordnen ist, dass sich der Spalt zwischen dem Halbleiterchip und dem Polschuh einerseits und dem Magneten andererseits befindet. Ist dann die gewünschte Position dieser Teile erreicht, so wird das Innere des Gehäuses zusätzlich mit einer Isoliermasse, z.B. aus Kunststoff vergossen und damit die genannte Position fixiert.

In Alternative hierzu kann man das Gehäuse einsparen und die für die Fertigstellung der Magnetschranke erforderliche Position der beiden Teile des Magnetleitblechs mittels einer geeigneten Klammer festhalten und durch Verspritzen mit Kunststoff fixieren.

Die Figur zeigt einen Schnitt durch die aufgrund der ersten Variante des erfindungsgemässen Verfahrens erhaltene Magnetschranke.

Die aufgrund des erfindungsgemässen Verfahrens erhaltene Hall-Magnetschranke 1 besteht aus einem Magneten 2, der z.B. aus Samarium-Kobalt besteht und der auf einen ersten Teil 3 eines Magnetleitblechs aufgeklebt ist. Weiter ist ein mit einer integrierten Schaltung versehenes Halbleiterchip 4 vorgesehen, welches mittels fingerartiger Kontaktstrukturen 9 an einem Zwischenträger 11, z.B. aus Kapton, befestigt ist, wobei die fingerartigen Strukturen in eine Aussparung 10 des Zwischenträgers 11 hineinragen, so dass das Halbleiterchip 4 lediglich an den fingerartigen Kontaktstrukturen 9 befestigt ist und im übrigen frei schwebt. Die fingerartigen Kontaktstrukturen 9 sind einerseits mit Kontakten, die in der Zeichnung nicht dargestellt sind, am Halbleiterchip 4 verlötet und andererseits mit Kontaktflecken, die ebenfalls in der Zeichnung nicht dargestellt sind, auf dem Zwischenträger 11 verlötet. Diese Kontaktflecken auf dem Zwischenträger 11 sind wiederum mit entsprechenden (in der Zeichnung nicht dargestellten) Kontaktflecken auf einer Kunststoffplatine 7 (z.B. aus glasfaserverstärktem Hartepoxyd) verlötet. Von den Kontaktflecken auf der Kunststoffplatine 7 führen (ebenfalls in der Zeichnung nicht dargestellte) Kontaktstrukturen entlang der Oberfläche der Kunststoffplatine 7 zu äusseren Anschlussdrähten 12, mit denen sie leitend verbunden sind. Da das Halbleiterchip 4 mit der Oberfläche 13 des Zwischenträgers 11 nicht eben abschliesst, ist der Polschuh 8 am zweiten Teil 5 des Magnetleitblechs mit einer Aussparung 14 versehen, die gewährleistet, dass das Halbleiterchip nirgends am Polschuh 8 aufliegt. In ein vorgefertigtes Gehäuse 15, z.B. bestehend aus Kunststoff, wird einerseits der erste Teil 3 des Magnetleitblechs, versehen mit dem Magneten 2, eingeführt, und andererseits der zweite Teil 5 des Magnetleitblechs, versehen mit dem Halbleiterchip 4, dem Zwischenträger 11, der Kunststoffplatine 7 sowie den angelöteten äusseren Anschlussdrähten 12, eingeführt. Das Gehäuse 15 ist bis auf die Fläche 16 allseitig geschlossen. Der Innenraum des Gehäuses 17 ist zusätzlich mit einem, z.B. aus Kunststoff bestehenden Isolator so ausgegossen, dass er die Ansatzstellen 18 zwischen den äusseren Anschlussdrähten 12 und der Kunststoffplatine 7 überdeckt. Der Spalt 19 zwischen dem Magneten 2 und dem Halbleiterchip 4 beträgt ca. 1,2 mm bis 4,2 mm, insbesondere 2,2 mmm bis 3,2 mm.

Die Wand des Gehäuses 15 bildet eine zum Spalt 19 zwischen dem Magneten 2 und dem Halbleiterchip 4 gehörende Einbuchtung 20. Innerhalb dieser Einbuchtung 20 ist eine drehbare ferromagnetische Platte angeordnet, die mit Aussparungen versehen und in der Zeichnung nicht dargestellt ist, und die die Aufgabe hat, die Hall-Magnetschranke 1 zu öffnen bzw. zu schliessen. Der den freien Zwischenraum im Gehäuse 17 ausfüllende Kunststoff sorgt ersichtlich dafür, dass die relative Lage der einzelnen Bestandteile der Magnetschranke erhalten bleibt.

Anstelle der Verwendung eines Gehäuses 15 mit anschliessendem Kunststoffverguss können auch die einzelnen Teile, nachdem sie wie anfangs beschrieben zusammengefügt sind, mittels einer — z.B. aus Aluminium bestehenden — Haltklammer in der erforderlichen Lage zueinander gehaltert und mit Kunststoff umspritzt werden. Damit hat man dann die zweite Variante einer erfindungsgemäss hergestellten Magnetschranke.

Es ist ist nicht zwingend, einen Magneten aus Samarium-Kobalt-Legierung zu verwenden, obwohl sich solche Magneten aus den genannten Gründen und damit ihrer besonders kleinen Dimensionierung besonders empfehlen. Die beiden Magnetleitblechteile 3 und 5 bestehen aus einem ferromagnetischen Material. Das Halbleiterchip 4 besteht wohl in den meisten Fällen aus Silicium. Die aufgrund des erfindungsgemässen Verfahrens in seinen beiden Variationen erhaltenen Magnetschranken finden Anwendung als Positionsmelder bezüglich Translationsbewegungen sowie Rotationsbewegungen, z.B. bei Werkzeugmaschinen als Endlagenschalter, oder bei Bandmontagen, um das Vorrücken des Bandes geeignet zu regulieren. Miteinander kombinierte Magnetschranken können zum Abfragen codierter Eigenschaften benutzt werden. Sie eignen sich schliesslich auch als berührungslose Schaltorgane.

Magnetschranken, mit deren Herstellung sich die vorliegende Erfindung befasst, sind z.B. in Siemens Bauteile Report 15 (1977) Heft 4, S. 140-142, beschrieben. Jedoch ist dort ein der vorliegenden Erfindung entsprechendes Herstellungsverfahren weder beschrieben noch in irgendeiner Weise nahegelegt. Dasselbe kann im Hinblick auf den Stand der Technik nach der US-Patentschrift 4 156 820 festgestellt werden.

**Patentansprüche**

1. Verfahren zum Herstellen einer Magnetschranke, bei dem die zu erzeugende Magnetschranke aus einem Magneten mit einem einen ebenen Oberflächenteil aufweisenden Pol sowie aus einem mit einer integrierten Schaltung versehenen Halbleiterchip besteht, dadurch gekennzeichnet, dass das in Mikropack-Bauform vorliegende Halbleiterchip auf einen dünnen, mit fingerartigen Kontaktstrukturen (9) versehenen und z.B. aus einem Kunststoffband bestehenden Zwischenträger (11) aufgelötet und der Zwischenträger (11) mit einem für die Aufnahme der Oberseite des Halbleiterchips (4) mit einer Aussparung versehenen sowie einen ersten Teil (5) eines Magnetleitblechs (3, 5) bildenden Polschuh (5) fest verbunden wird, dass ausserdem auf den Zwischenträger (11) eine mit Kontaktstrukturen versehene Kunststoffplatine (7) an den äusseren Enden der Kontaktstrukturen mit äusseren Anschlussdrähten (12) versehen wird, dass ferner der Magnet (2) an einem weiteren Teil (3) des Magnetleitblechs (3, 5, 8) befestigt wird und dass schliesslich die beiden zunächst noch voneinander getrennten Teile (3, 5, 8) des Magnetleitblechs derart zueinander in Position gebracht werden, dass der Polschuh (2) mit dem Halbleiterchip (4) einerseits und ein ebener Oberflächenteil des Magneten (2) andererseits mit Abstand (20) einander gegenüber angeordnet sind und in dieser Position die beiden Teile des Magnetleitblechs (3, 5) abseits vom Halbleiterchip (4) mit dem Magneten (2) und dem Polschuh (8) in unmittelbarer magnetischer Verbindung miteinander stehen und dass dann diese Position unter Anwendung einer Einbettung (17) aus isolierendem Kunststoff fixiert wird.

2. Verfahren nach Anspruch 1, dadurch gekennzeichnet, dass die beiden Teile (3, 5, 8) des Magnetleitblechs in ein vorgefertigtes und z.B. aus Kunststoff bestehendes Gehäuse (15) derart eingeschoben werden, dass die aktiven Teile (2, 4, 8) der Magnetschranke in die für das Funktionieren der Magnetschranke erforderliche Position gelangen sowie der Magnet (2) sich an der einen Seite und das Halbleiterchip (4) mit dem Polschuh (8) auf der anderen Seite einer spaltartigen Einbuchtung (20) des Gehäuses (15) sich befinden und dass dann diese Position durch Vergiessen des Gehäuseinneren mit der Isoliermasse fixiert wird.

3. Verfahren nach Anspruch 1, dadurch gekennzeichnet, dass die beiden Teile (3, 5, 8) des Magnetleitblechs mittels einer Klammer in der für das Funktionieren der Magnetschranke erforderlichen Position gehalten und dabei mit isolierendem Kunststoff derart umspritzt werden, dass ein zum Öffnen und Schliessen der Magnetschranke vorzusehendes Organ in Gestalt einer drehbaren, mit Aussparungen versehenen ferromagnetischen Platte zwischen den Magneten (2) und dem Halbleiterchip (4) einschiebbar ist.

4. Verfahren nach einem der Ansprüche 1 bis 3, dadurch gekennzeichnet, dass ein aus einer Samarium-Kobalt-Legierung bestehender Magnet (2) verwendet wird.

5. Verfahren nach einem der Ansprüche 1 bis 4, dadurch gekennzeichnet, dass die zu verwendende Kunststofffixierung aus Epoxydharz besteht.

## Claims

1. Process for the manufacture of a magnetic pass-through detector, in which the magnetic pass-through detector to be manufactured consists of a magnet with a pole, having a flat surface portion, and a semiconductor chip provided with an integrated circuit, characterised in that the semiconductor chip, which is present in the form of a micro-pack construction, is soldered onto a thin intermediate carrier (11), which is provided with finger-shaped contact structures (9) and consists, for example, of a synthetic resin strip; and the intermediate carrier (11) is fixedly connected to a pole shoe (5), which is provided with a recess to accommodate the upper side of the semiconductor chip (4) and forms a first part (5) of a magnetic guide plate (3, 5); that, moreover, on the intermediate carrier (11), there is provided a synthetic resin plate (7) which is provided with contact structures, with external connection wires (12) at the outer ends of the contact structures; that further the magnet (2) is secured to a further part (3) of the magnetic guide plate (3, 5, 8); and that finally the two parts (3, 5, 8) of the magnetic guide plate, which at first are still separated from one another, are brought into position with respect to one another in such a way that the pole shoe (8) with the semiconductor chip (4), on the one hand, and a flat surface portion of the magnet (2), on the other hand, are arranged opposite one another with an interval (20), the two parts of the magnetic guide plate (3, 5), apart from the semiconductor chip (4), being in this position in direct magnetic connection with the magnet (2) and the pole shoe (8), and that this position is then fixed by the use of an insulating synthetic resin embedding (17).

2. A process according to claim 1, characterised in that the two parts (3, 5, 8) of the magnetic guide plate are inserted into a prefabricated housing (15), consisting, for example, of synthetic resin, in such a way that the active parts (2, 4, 8) of the magnetic pass-through detector reach the position required for the functioning of the magnetic pass-through detector, and the magnet (2) lies on the one side and the semiconductor chip (4) with the pole shoe (8) on the other side of a cleft-shaped indentation (20) of the housing (15); and that this position is then fixed by filling the inside of the housing with the insulating material.

3. A process according to claim 1, characterised in that the two parts (3, 5, 8) of the magnetic guide plate are held in the position which is required for the functioning of the magnetic pass-through detector, by means of a clamp and are sprayed with insulating synthetic resin in such a way that an element which is to be provided for opening and closing the magnetic pass-through detector and which is in the form of a rotatable ferromagnetic plate provided with openings, can be inserted between the magnet (2) and the semiconductor chip (4).

4. A process according to one of claims 1 to 3, characterised in that a magnet (2) made of a samarium-cobalt alloy is used.

5. A process according to one of claims 1 to 4, characterised in that the synthetic resin fixing to be used, consists of epoxy resin.

## Revendications

1. Procédé pour fabriquer un dispositif magnétique de passage, selon lequel le détecteur magnétique de passage devant être fabriqué est constitué par un aimant comportant un pôle possédant un élément de surface plan, et par une microplaquette à semiconducteurs équipée d'un circuit intégré, caractérisé par le fait qu'on soude la microplaquette à semiconducteur présente sous la forme d'un micromodule, sur un support intermédiaire mince (11) muni de structures de contact (9) en forme de doigts et constitué par exemple par une bande en matière plastique, et qu'on fixe rigidement le support intermédiaire (11) à une pièce polaire (5) munie d'un évidement servant à loger la face supérieure de la microplaquette à semiconducteurs (4) et constituant une première partie (5) d'une tôle magnétique conductrice (3, 5), qu'en outre, sur le support intermédiaire (11), on soude une plaque en matière plastique (7) munie de structures de contact à des zones de contact du support intermédiaire et on équipe la platine de fils extérieurs de connexion (12) sur les extrémités extérieures de structures de contact, qu'on fixe en outre l'aimant (2) sur une autre partie (3) de la tôle magnétique conductrice (3, 5, 8) et qu'on place enfin les deux parties (3, 5, 8), d'abord encore séparées l'une de l'autre, de la tôle magnétique conductrice dans des positions réciproques telles que la pièce polaire (8) munie de la plaquette à semiconducteurs (4) d'une part et un élément de surface plan de l'aimant (2) d'autre part sont disposés en vis-à-vis à une distance réciproque (20) et que dans cette position, les deux pièces de la tôle magnétique conductrice sont reliées selon une liaison magnétique directe avec l'aimant (2) et avec la pièce polaire (8), et ce à l'écart de la microplaquette à semiconducteurs (4), et qu'on bloque alors ces pièces dans cette position, en utilisant une masse de remplissage (17) constituée par une matière plastique isolante.

2. Procédé suivant la revendication 1, caractérisé par le fait qu'on insère les deux parties (3, 5, 8) de la tôle magnétique conductrice dans un boîtier préfabriqué (15) constitué par exemple en une matière plastique, de telle sorte que les parties actives (2, 4, 8) du détecteur magnétique de passage viennent dans la position nécessaire pour le fonctionnement de ce détecteur et que l'aimant (2) est situé sur une face d'un renfoncement (20) en forme de fente du boîtier (15) et que la microplaquette à semiconducteurs (4) munie de la pièce polaire (8) est située de l'autre côté de ce renfoncement et qu'on fixe ces éléments en position en coulant la masse à l'intérieur du boîtier.

3. Procédé suivant la revendication 1, caractérisé par le fait qu'on maintient les deux pièces (3, 5, 8) de la tôle magnétique conductrice au moyen d'une pince dans la position nécessaire pour le fonctionnement du détecteur magnétique de passage et qu'on recouvre l'ensemble par injection avec une matière plastique isolante, et qu'un organe servant à ouvrir et à fermer le détecteur magnétique de passage et réalisé sous la forme d'une plaque ferromagnétique rotative équipée d'évidements peut être insérée entre l'aimant (2) et la microplaquette à semiconducteurs (4).

4. Procédé suivant l'une des revendications 1 à 3, caractérisé par le fait qu'on utilise qu'un aimant (2) constitué par un alliage de samarium et de cobalt.

5. Procédé suivant l'une des revendications 1 à 4, caractérisé par le fait que la fixation en matière plastique devant être utilisée est constituée par une résine époxy.